**Europäisches Patentamt**

(19) **European Patent Office**

**Office européen des brevets**

(11) Numéro de publication: **0 089 621**
**B1**

(12) # FASCICULE DE BREVET EUROPEEN

(45) Date de publication du fascicule du brevet:
**27.08.86**

(51) Int. Cl.⁴: **F 16 J 15/54,** G 12 B 3/06,
H 01 J 37/00

(21) Numéro de dépôt: **83102628.1**

(22) Date de dépôt: **17.03.83**

(54) Traversée étanche.

(30) Priorité: **23.03.82 LU 84028**

(43) Date de publication de la demande:
**28.09.83 Bulletin 83/39**

(45) Mention de la délivrance du brevet:
**27.08.86 Bulletin 86/35**

(84) Etats contractants désignés:
**DE FR GB IT**

(56) Documents cités:
**FR - A - 576 073
US - A - 3 289 466**

**FEINWERKTECHNIK; vol. 66, décembre 1962, pages 453-455, C.F. Winter'sche Verlagshandlung, Prien, Chiemsee, DE. B.A. KOMASCHINSKI: "Die Kompensation der Reibung in Lagern für drehende Wellen"**

(73) Titulaire: **COMMUNAUTE EUROPEENNE DE L'ENERGIE ATOMIQUE (EURATOM), Bâtiment Jean Monnet Plateau du Kirchberg Boîte Postale 1907, L-1019 Luxembourg (LU)**

(72) Inventeur: **Causse d'Agraives, Bertrand François, 62, via Leggiuno, I-21014 Laveno (IT)**
Inventeur: **Toornvliet, Jan, 25, via Garibaldi, I-Orino (VA) (IT)**

(74) Mandataire: **Weinmiller, Jürgen, Zeppelinstrasse 63, D-8000 München 80 (DE)**

## Description

L'invention concerne une traversée étanche d'un arbre rotatif à travers une paroi, avec deux joints coaxiaux, dont le premier se trouve entre la paroi et une couronne rotative coaxiale, et le deuxième se trouve entre cette couronne et l'arbre, ladite couronne étant entraînée en rotation.

Dans la présente description, le terme «traversée étanche» est destiné à couvrir également les traversées présentant une situation de fuite limitée et stable.

Pour une traversée étanche conventionnelle, le couple de friction augmente avec le diamètre des arbres et avec la pression différentielle à laquelle est soumis le joint d'étanchéité.

Il a déjà été proposé de compenser le couple dûe au frottement du joint, voir par exemple le document US-A-3 289 466. Selon ce document, l'arbre traverse complètement une enceinte de telle sorte, qu'il ressort de celle-ci de l'autre côté. On y prévoit un joint annulaire, qui est porté par une couronne rotative, elle-même entraînée en rotation par un moteur de compensation. Un second joint annulaire assure l'étanchéité entre la couronne et la paroi de l'enceinte. La vitesse et la direction de rotation de la couronne sont choisies de façon que le couple dû au frottement du joint dans la première paroi soit au moins approximativement compensé par le couple que le joint situé dans la couronne exerce sur l'arbre.

Un désavantage d'une telle traversée réside dans le fait que la compensation ne fonctionne que lorsque l'arbre est en rotation. A l'arrêt de l'arbre, par contre, il faut arrêter également la couronne pour annuler le couple résiduel. Or, le frottement statique joint/arbre et les caractéristiques élastiques du joint influent sur le couple statique que l'on doit vaincre pour mettre l'arbre en rotation. Pour un joint donné, ce couple a une valeur beaucoup plus aléatoire que le couple dynamique qui est, pour une plage de vitesse donnée, stable. S'il y a lieu de transmettre un couple relativement faible (par exemple lorsqu'on effectue une mesure), les irrégularités du couple statique empêchent une rotation régulière à très basse vitesse.

Par le document FR-A 576 073, on connaît un dispositif permettant de supprimer l'influence du frottement sur l'état de repos d'un arbre rotatif. Selon ce document, l'arbre traversant l'enceinte de part et d'autre est logé dans des paliers qui eux-mêmes sont entraînés en rotation. Ainsi, les paliers sont toujours en mouvement, même si l'arbre est à l'arrêt. Pour que le frottement dans les paliers n'introduise pas un couple de rotation à l'arbre, les deux paliers sont entraînés en rotation en sens inverse.

Dans un article paru dans le périodique «Feinwerktechnik», vol. 66, (1962), pages 453 à 455, on approfondit la théorie de compensation des forces résultant du frottement dans les deux paliers d'un arbre tournant. Il en résulte la proposition d'entraîner les deux paliers en une rotation de vitesse notablement plus grande que la vitesse de rotation de l'arbre lui-même. Néanmoins, l'auteur de cet article a observé des couples résiduels, qui peuvent agir soit en direction de rotation de l'arbre, soit en contresens. Bien sûr, de tels couples résiduels sont notablement plus grands lorsque les paliers sont associés à des joints frottants. Il est donc un but de la présente invention de réduire ce couple résiduel surtout dans le cas où l'arbre ne traverse qu'une seule paroi, ce qui augmente encore l'asymétrie qui est la source du couple résiduel. L'invention s'applique en particulier à une traversée étanche d'un arbre à travers une paroi lorsque l'arbre tourne toujours dans le même sens. On sait en effet qu'une telle situation est favorable à la naissance de couples résiduels dans les configurations de l'art antérieur, où les deux paliers sont entraînés en contresens mutuel, car la rotation de l'arbre augmente la différence de vitesse entre l'arbre et l'un des paliers, alors que cette différence est diminuée dans l'autre.

Ce but est atteint selon l'invention par les mesures définies dans la revendication.

L'invention sera décrite ci-après à l'aide d'un exemple de réalisation et des dessins.

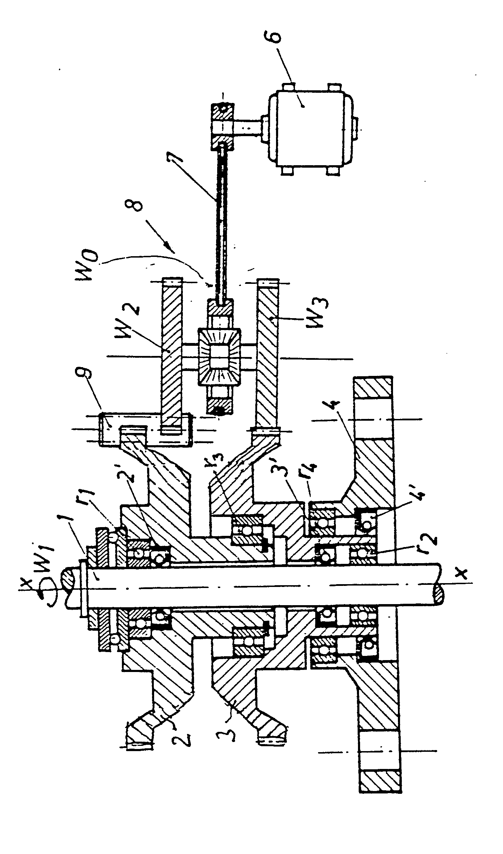

La figure unique représente une coupe à travers une traversée selon l'invention.

Un arbre 1 tournant à une vitesse $w_1$ autour de son axe x-x traverse deux couronnes 2 et 3 et une paroi 4. La couronne 2 porte un joint 2' et un palier $r_1$ en regard de l'arbre. De même, la couronne 3 porte un joint 3' et un palier $r_2$ en regard de l'arbre. Un troisième joint 4' et un troisième palier $r_4$ sont interposés entre la couronne 3 et la paroi 4. Un moteur 6 est accouplé à travers une courroie 7 et un différentiel 8 à deux roues dentées $W_2$ et $W_3$, dont l'une est directement accouplée à la couronne 3, alors que l'autre est accouplée à la couronne 2 à travers un engrenage d'inversion 9. Les vitesses de rotation $w_2$ et $w_3$ des roues $W_2$ et $W_3$ sont déterminées en fonction des plages de vitesse prévisibles $w_1$ de l'arbre 1. Grâce au différentiel, la différence $w_2-w_3$ est toujours constante, $w_1$ étant toujours compris entre $w_2$ et $w_3$. Dans ce système, le couple d'entraînement de la couronne 2 sur l'arbre 1 est équilibré par le couple frein de la couronne 3 sur l'arbre 1 et vice-versa.

Un autre palier $r_3$ est interposé entre les deux couronnes 2 et 3 dans le seul but d'une stabilisation mécanique des deux couronnes.

Grâce à l'engrenage d'inversion 9, les deux couronnes 2 et 3 tournent dans le même sens que l'arbre, l'une plus vite et l'autre plus lentement. Ainsi, le couple dû au frottement dans le joint 2' se voit compensé par le couple antagoniste du joint 3', alors que le couple exercé par le joint 4' n'a pas effet sur la rotation de l'arbre 1, l'énergie nécessaire pour viancre le couple de frottement de tous les joints étant fournie par le moteur 6.

## Revendication

1. Traversée étanche d'un arbre rotatif (1) à travers une paroi (4), avec au moins deux joints coaxiaux (3, ', 4'), dont le premier (4') se trouve entre la paroi (4) et une couronne (3) rotative coaxiale, et le deuxième (3') se trouve entre cette couronne et l'arbre (1), ladite couronne étant entraînée en rotation, caractérisé par le fait qu'une seconde couronne coaxiale (2) est disposée sur cet arbre, un troisième joint coaxial (2') étant interposé entre cet arbre (1) et cette couronne (2), cette couronne étant également entraînée en rotation, les deux couronnes ètant entraînées en sens unique par un moteur commun (6) à travers un tel engrenage (9), que la différence entre les vitesses ($w_2$, $w_3$) de rotation des deux couronnes (2, 3) soit constante (2k), la vitesse ($w_1$) de rotation de l'arbre (1) étant comprise entre les vitesses de rotation ($w_2$ et $w_3$) des deux couronnes (2, 3).

## Patentanspruch

Dichte Durchführung einer drehenden Welle (1) durch eine Wand (4), mit mindestens zwei koaxialen Dichtungen (3', 4'), von denen die erste (4') sich zwischen der Wand (4) und einem koaxialen drehenden Zahnkranz (3) und die zweite (31) sich zwischen diesem Zahnkranz und der Welle (1) befindet, wobei der Zahnkranz in Drehung versetzt wird, dadurch gekennzeichnet, dass ein zweiter koaxialer Zahnkranz (2) auf dieser Welle angeordnet ist, wobei eine dritte koaxiale Dichtung (2') zwischen dieser Welle und diesem Zahnkranz (2) angeordnet ist und dieser Zahnkranz ebenfalls in Drehung versetzt wird, wobei die beiden Zahnkränze in eine gemeinsame Richtung von einem gemeinsamen Motor (6) über ein solches Getriebe (9) angetrieben werden, dass der Unterschied zwischen den Drehgeschwindigkeiten ($w_2$, $w_3$) der beiden Zahnkränze (2, 3) konstant ist (2k), wobei die Drehgeschwindigkeit ($w_1$) der Welle zwischen den Drehgeschwindigkeiten ($w_2$ und $w_3$) der beiden Zahnkränze liegt.

## Claim

A sealed passage of a rotary shaft (1) through a wall (4), with at least two coaxial seals (3', 4'), the first of which (4') is situated between the wall (4) and a coaxial rotary crown (3) and the second of which is located between this crown and the shaft (1), said crown being driven into rotation, characterized in that a second coaxial crown (2) is disposed on this shaft, a third coaxial seal (2') being inserted between this shaft (1) and this crown (2), this crown being equally driven into rotation, the two crowns being driven in one direction by a common motor (6) through a gear (9) such that the difference between the rotation speeds ($w_2$ $w_3$) of the two crowns (2, 3) is constant (2k), the rotation speed ($w_1$) of the shaft being comprised between the rotation speeds ($w_2$ and $w_3$) of the two crowns (2, 3).

0 089 621